# EUROPEAN PATENT APPLICATION

(11) **EP 3 893 268 A1**
(43) Date of publication of application: **13.10.2021**
(21) Application number: 19891990.4
(22) Date of filing: 06.12.2019
(51) Int. Cl.: H01L 21/205, C23C 16/458, C23C 16/52

(54) **FILM FORMATION METHOD, FILM FORMATION DEVICE, SUSCEPTOR UNIT, AND SPACER SET USED IN SUSCEPTOR UNIT**

(30) Priority: 07.12.2018 JP 2018229825
(71) Applicant: NuFlare Technology, Inc., Yokohama-shi, Kanagawa 235-8522 (JP)
(72) Inventor: DAIGO, Yoshiaki, Yokohama-shi, Kanagawa 235-8522 (JP)
(74) Representative: Hoffmann Eitle
(86) International application number: PCT/JP2019/047840
(87) International publication number: WO 2020/116618

(57) **Abstract**

According to one embodiment, a deposition method includes: placing a wafer on a susceptor unit, the susceptor unit including: a supporting member configured to place a wafer thereon; a side guide that is provided on the supporting member and that surrounds at least a part of an outer periphery of the wafer; and a spacer configured to adjust a position of an upper surface of the wafer and a position of an upper surface of the side guide; depositing a predetermined film on the upper surface of the wafer placed and forming a film on the side guide; adjusting the position of the upper surface of the side guide with respect to the upper surface of the wafer using the spacer, based on a thickness of the predetermined film deposited; and placing a new wafer on the susceptor unit that has been adjusted in terms of the position for depositing a new predetermined film.

## Description

### FIELD

The embodiment relates to a deposition method, a deposition apparatus, a susceptor unit, and a spacer set used in the susceptor unit.

### BACKGROUND

A deposition apparatus that deposits a film on an upper surface (surface on which a film is to be deposited) of a wafer by epitaxial growth is known. Hereinafter, depositing a predetermined film on an upper surface of a wafer will be referred to as a deposition process. In a deposition apparatus using a chemical vapor deposition (CVD) method, a deposition chamber in which the concentration of a process gas, the chemical reaction temperature, and the like are controlled is provided. A wafer is placed on a susceptor inside the deposition chamber, and a process gas is supplied to the upper surface of the wafer. As a result, a predetermined film is deposited on the upper surface of the wafer.

The susceptor is configured of, for example, carbon, silicon carbide (SiC), carbon coated with SiC, or carbon coated with tantalum carbide (TaC). When the predetermined film is deposited on the upper surface of the wafer, not only is the film deposited on the upper surface of the wafer but also a deposit is formed on the upper surface of the susceptor. For various reasons, the deposit formed on the upper surface of the susceptor at this time is not necessarily the same film as the film deposited on the upper surface of the wafer. As the deposition process is repeated using the susceptor, the deposit on the upper surface of the susceptor becomes thicker. As a result, the position in the height direction (hereinafter referred to as a position) of the upper surface of the susceptor on which a film has been deposited by repeating the deposition process with respect to the upper surface of the wafer prior to deposition of an epitaxial film changes, possibly causing a change in conditions for the deposition process (deposition conditions). Such a change in deposition conditions may affect the thickness and properties of the film that can be obtained.

Patent Document 1, for example, discloses a susceptor apparatus including a motor that adjusts the position of an upper surface of a susceptor on which a deposit has been formed with respect to an upper surface of a wafer.

### CITATION LIST

### PATENT LITERATURE

Patent Document 1: Jpn. Pat. Appln. KOKAI Publication No. 2007-180153

### SUMMARY

### TECHNICAL PROBLEM

An object of an embodiment is to achieve a stable deposition process while maintaining conditions for deposition on a wafer, even if a deposit is formed on a susceptor unit.

### SOLUTION TO PROBLEM

According to one embodiment, a deposition method includes: placing a wafer on a susceptor unit, the susceptor unit including: a supporting member configured to place a wafer thereon; a side guide that is provided on the supporting member and that surrounds at least a part of an outer periphery of the wafer; and a spacer configured to adjust a position between an upper surface of the wafer and an upper surface of the side guide; depositing a predetermined film on the upper surface of the wafer placed and forming a film on the side guide; adjusting the position of the upper surface of the side guide with respect to the upper surface of the wafer using the spacer, based on a thickness of the predetermined film deposited; and placing a new wafer on the susceptor unit that has been adjusted in terms of the position for depositing a new predetermined film.

### ADVANTAGEOUS EFFECTS OF INVENTION

According to the present invention, even if a deposit is formed on the susceptor unit, a stable deposition process can be achieved while maintaining conditions for deposition on a wafer.

### BRIEF DESCRIPTION OF THE DRAWINGS

FIG. 1 is a diagram schematically showing a configuration example of a deposition system according to an embodiment.
FIG. 2 is a diagram schematically showing a configuration example of a deposition apparatus according to the embodiment.
FIG. 3 is a perspective view schematically showing a configuration example of a susceptor unit according to the embodiment.
FIG. 4 is a cross-sectional view schematically showing a configuration example of a susceptor unit according to the embodiment.
FIG. 5A is a schematic view for illustrating a flow of a process gas during a deposition process, showing a case where a difference in height between an upper surface of a side guide of the susceptor unit and an upper surface of a wafer is small.
FIG. 5B is a schematic view for illustrating a flow of a process gas during a deposition process, showing a case where a difference in height between an upper surface of a side guide of the susceptor unit and an upper surface of a wafer is large.
FIG. 6A is a cross-sectional view schematically showing a configuration example of a susceptor unit according to the embodiment, showing a case where a deposit is formed on a side guide of the susceptor unit.
FIG. 6B is a cross-sectional view schematically showing a configuration example of a susceptor unit according to the embodiment, showing a case where a deposit is further formed on the side guide of the susceptor unit.
FIG. 7 is a flowchart schematically showing an example of a procedure in the case where a deposition process is repeated according to the embodiment.
FIG. 8A is a cross-sectional view schematically showing a configuration example of a susceptor unit according to a first modification.
FIG. 8B is a cross-sectional view schematically showing a configuration example of a susceptor unit according to the first modification, showing a case where a deposit is formed on a side guide of the susceptor unit.
FIG. 8C is a cross-sectional view schematically showing a configuration example of a susceptor unit according to the first modification, showing a case where a deposit is further formed on the side guide of the susceptor unit.
FIG. 9A is a cross-sectional view schematically showing a configuration example of a susceptor unit according to a second modification.
FIG. 9B is a cross-sectional view schematically showing a configuration example of a susceptor unit according to the second modification, showing a case where a deposit is formed on a side guide of the susceptor unit.
FIG. 9C is a cross-sectional view schematically showing a configuration example of a susceptor unit according to the second modification, showing a case where a deposit is further formed on the side guide of the susceptor unit.
FIG. 10A is a cross-sectional view schematically showing a configuration example of a part of a susceptor unit according to a third modification.
FIG. 10B is a cross-sectional view schematically showing a configuration example of a part of a susceptor unit according to the third modification, showing a case where a film is deposited on a side guide of the susceptor unit.
FIG. 10C is a cross-sectional view schematically showing a configuration example of a part of a susceptor unit according to a fourth modification, showing a case where a deposit is further formed on the side guide of the susceptor unit.
FIG. 11A is a cross-sectional view schematically showing a configuration example of a part of the susceptor unit according to the fourth modification.
FIG. 11B is a cross-sectional view schematically showing a configuration example of a part of the susceptor unit according to the fourth modification, showing a case where a deposit is formed on a side guide of the susceptor unit.
FIG. 11C is a cross-sectional view schematically showing a configuration example of a part of the susceptor unit according to the fourth modification, showing a case where a deposit is further formed on the side guide of the susceptor unit.

### DETAILED DESCRIPTION

A deposition system according to an embodiment will be described with reference to the drawings. The deposition system of the present embodiment is a system for performing deposition using a CVD method. A wafer having an upper surface on which a film is to be deposited, is placed in a deposition chamber, the wafer being held by a susceptor unit. In the deposition chamber, a film is deposited on an upper surface of the wafer, and a deposit is similarly formed on an upper surface of the susceptor unit. In the deposition system, after the deposition on the wafer is completed, the wafer is removed from the susceptor unit. In the deposition system, another wafer is held by the susceptor unit, and deposition is performed. By thus repeating deposition while exchanging wafers, the deposit on the upper surface of the susceptor unit becomes thicker. The present embodiment has been devised in such a manner that the conditions for deposition on a wafer are not changed even if a deposit is formed on the upper surface of the susceptor unit. More specifically, the spacer (adjustment member) provided in the susceptor unit can be suitably replaced with a spacer with a different thickness, in such a manner that the height difference between the upper surface of the wafer and the upper surface of the susceptor unit does not change beyond a permissible value. The technique according to the present embodiment can be used for a deposition process using a CVD method or other vapor-phase growth methods, or other epitaxial growth methods.

### [System Configuration]

### <Deposition System>

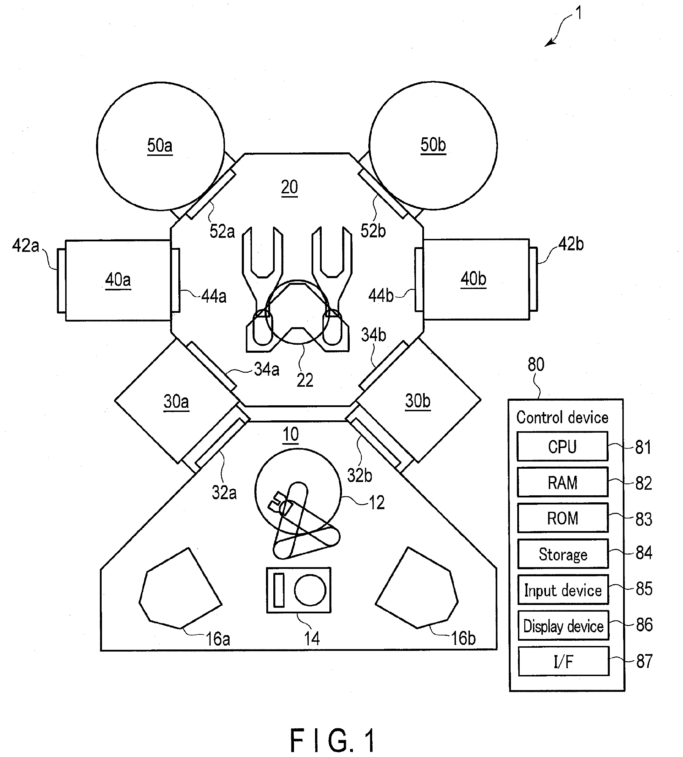

FIG. 1 schematically shows a configuration example of a deposition system 1 according to the present embodiment. The deposition system 1 includes an antechamber 10 and a transfer chamber 20. The deposition system 1 includes a first load lock chamber 30a, a second load lock chamber 30b, a first susceptor exchange chamber 40a, a second susceptor exchange chamber 40b, a first deposition chamber 50a, and a second deposition chamber 50b. The first load lock chamber 30a and the second load lock chamber 30b are equivalent, the first susceptor exchange chamber 40a and the second susceptor exchange chamber 40b are equivalent, and the first deposition chamber 50a and the second deposition chamber 50b are equivalent. That is, the deposition system 1 includes two systems of deposition apparatuses for performing deposition. Specifically, the deposition system 1 includes a first system including the first load lock chamber 30a, the first susceptor exchange chamber 40a, and the first deposition chamber 50a, and a second system including the second load lock chamber 30b, the second susceptor exchange chamber 40b, and the second deposition chamber 50b.

The first load lock chamber 30a communicates with a antechamber 10 via a first gate valve 32a, and communicates with a transfer chamber 20 via a second gate valve 34a. Similarly, the second load lock chamber 30b communicates with the antechamber 10 via a third gate valve 32b, and communicates with the transfer chamber 20 via a fourth gate valve 34b. The wafer can be transferred between the antechamber 10 and the transfer chamber 20 by means of the first load lock chamber 30a and the second load lock chamber 30b.

The first susceptor exchange chamber 40a communicates with the outside via a fifth gate valve 42a, and communicates with the transfer chamber 20 via a sixth gate valve 44a. Similarly, the second susceptor exchange chamber 40b communicates with the outside via a seventh gate valve 42b, and communicates with the transfer chamber 20 via an eighth gate valve 44b. A susceptor unit can be transferred between the outside and the transfer chamber 20 by means of the first susceptor exchange chamber 40a and the second susceptor exchange chamber 40b.

The first deposition chamber 50a communicates with the transfer chamber 20 via a ninth gate valve 52a. Similarly, the second deposition chamber 50b communicates with the transfer chamber 20 via a tenth gate valve 52b.

The transfer chamber 20 is provided with a robot 22. The robot 22 is configured to transfer a wafer or a susceptor unit on which a wafer is placed into and out of the first load lock chamber 30a, the second load lock chamber 30b, the first susceptor exchange chamber 40a, the second susceptor exchange chamber 40b, the first deposition chamber 50a, or the second deposition chamber 50b.

The antechamber 10 is provided with a robot 12, an aligner 14, a first cassette 16a, and a second cassette 16b. A wafer to be transferred via the first load lock chamber 30a is placed on the first cassette 16a. A wafer to be transferred via the second load lock chamber 30b is placed on the second cassette 16b. A wafer is transferred between the antechamber 10 and the first load lock chamber 30a and between the antechamber 10 and the second load lock chamber 30b, using the robot 12 and the aligner 14.

A susceptor unit is loaded into the first susceptor exchange chamber 40a from the outside via the fifth gate valve 42a. Similarly, a susceptor unit is loaded into the second susceptor exchange chamber 40b from the outside through the seventh gate valve 42b.

The robot 22 of the transfer chamber 20 takes out the wafer in the first load lock chamber 30a via the second gate valve 34a, and places the wafer on the susceptor unit loaded into the first susceptor exchange chamber 40a. The robot 22 takes out the susceptor unit on which the wafer in the first susceptor exchange chamber 40a has been placed from the first susceptor exchange chamber 40a, and places the susceptor unit in the first deposition chamber 50a. In the first deposition chamber 50a, an epitaxial film of, for example, SiC is deposited on the upper surface of the wafer by, for example, a CVD method. The susceptor unit is configured of carbon, SiC, carbon coated with SiC, carbon coated with TaC, or the like. In addition, materials of individual components configuring the susceptor unit can be individually selected according to the objective.

The robot 22 of the transfer chamber 20 takes out the susceptor unit holding the wafer on which the film has been deposited from the first deposition chamber 50a, and places the susceptor unit in the first susceptor exchange chamber 40a. The robot 22 takes out the wafer on which the film has been deposited from the susceptor unit in the first susceptor exchange chamber 40a, and puts the wafer into the first load lock chamber 30a. The wafer on which the film has been deposited in the first load lock chamber 30a is taken out by the robot 12 of the antechamber 10, and is put into the first cassette 16a.

By repeating the above-described process, crystal films are sequentially deposited on a plurality of wafers. A configuration may be adopted in which a cassette is provided in each of the first load lock chamber 30a and the first susceptor exchange chamber 40a, and a plurality of wafers are placed in each chamber.

The same applies to wafer transfer between the antechamber 10, the second load lock chamber 30b, the second susceptor exchange chamber 40b, and the second deposition chamber 50b.

The deposition system 1 includes a control device 80 that controls the operation of each component of the deposition system 1. The control device 80 includes a central processing unit (CPU) 81, a random access memory (RAM) 82, a read only memory (ROM) 83, a storage 84, an input device 85, a display device 86, and an interface (I/F) 87, which are connected to each other via a bus line.

The CPU 81 performs various signal processing and the like. The operation of the CPU 81 is performed in accordance with, for example, programs and data stored in the RAM 82 and the ROM 83. For the storage 84, for example, a hard disk drive (HDD), a solid-state drive (SSD), or the like is used. In the storage 84, various kinds of information such as a program group and parameters necessary for executing the functions of the control device 80 are recorded. Programs necessary for operating the control device 80 are loaded from the storage 84 into the RAM 82, and executed by the CPU 81. The ROM 83 may store a boot processing program in order to load a program from the storage 84 to the RAM 82 at the time of activation of the control device 80. Any type of device with an equivalent function may be used as each of such devices. The control device 80 is connected to each component of the deposition system 1 via the I/F 87 in order to control each component of the deposition system 1, and inputs and outputs information necessary for the control.

### <Deposition Apparatus>

In the drawings to be referred to below, an X direction and a Y direction (which is orthogonal to the X direction) are parallel to an upper surface of a wafer on which a film is to be deposited, and a Z direction (which is orthogonal to the X and Y directions) corresponds to a vertical direction with respect to the upper surface of the wafer.

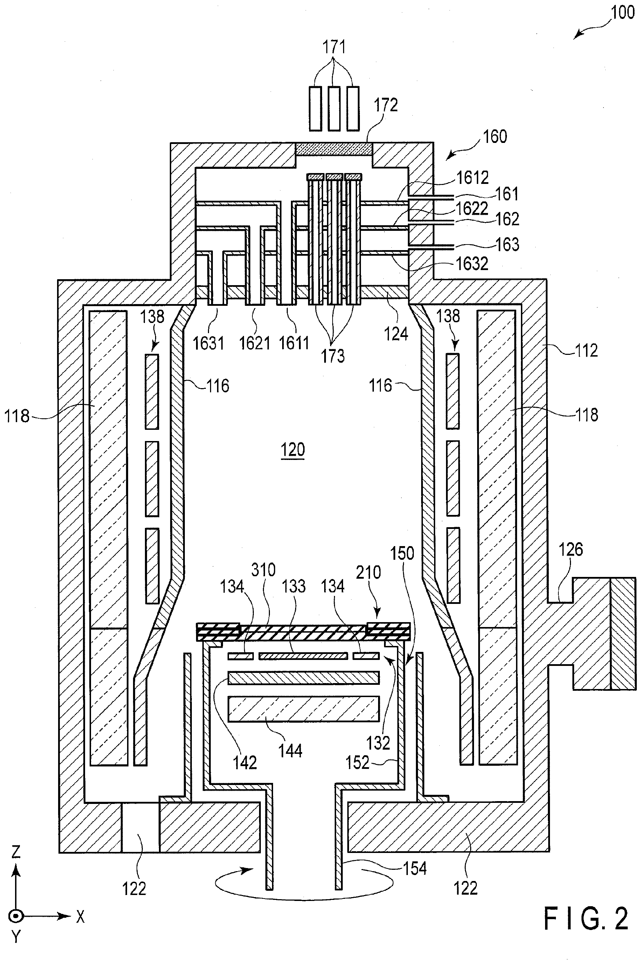

FIG. 2 is a diagram schematically showing a configuration example of a deposition apparatus 100 provided in the first deposition chamber 50a and the second deposition chamber 50b. The deposition apparatus 100 shown in FIG. 2 is a hot-wall thermal CVD apparatus. The deposition apparatus 100 is used for deposition of, for example, an SiC epitaxial film.

The deposition apparatus 100 includes a chamber 112 as a deposition chamber. In the chamber 112, a cylindrical hot wall 116, for example, is provided, and the inside of the hot wall 116 is a deposition area 120 that functions as a reaction chamber. A wafer 310 is placed in the susceptor unit 210 below the deposition area 120 as viewed in the Z direction. A process gas is supplied to the deposition area 120 from a gas supply unit 160 (supply port) provided thereabove as viewed in the Z direction. In the deposition apparatus 100, the process gas reacts on an upper surface of the wafer 310 held by the susceptor unit 210, and an SiC epitaxial film, for example, is deposited by a vapor phase growth reaction.

The susceptor unit 210 is placed on a rotary holder 150. The rotary holder 150 includes a cylindrical portion 152 and a rotation axis 154 fixed to a lower portion of the cylindrical portion 152. The cylindrical portion 152 is configured in such a manner that the susceptor unit 210 is placed on an upper portion thereof. The cylindrical portion 152 includes a large opening on a side on which the susceptor unit 210 is placed. A motor (not shown) is connected to the rotation axis 154. The rotary holder 150 is configured to be rotated by the motor. At the time of deposition, rotation of the rotary holder 150 causes the wafer 310 placed thereon and held by the susceptor unit 210 to rotate. The susceptor unit 210 that holds the wafer 310 is transferred to the chamber 112 via a load-in port 126.

A bottom heater 132 is provided inside the cylindrical portion 152. The bottom heater 132 heats the wafer 310 from a rear surface thereof via the opening of the cylindrical portion 152 and the lower portion of the susceptor unit 210. The bottom heater 132 includes a disc-shaped inside heater 133 disposed at its central portion and an annular outside heater 134 disposed at an outer periphery of the inside heater 133. For the inside heater 133 and the outside heater 134, electric-resistance-based heaters can be used. For example, the inside heater 133 and the outside heater 134 can be configured of carbon with a predetermined resistance value, SiC, carbon coated with SiC, carbon coated with TaC, or the like. Power is supplied to the bottom heater 132 by wiring (not illustrated) provided in the rotation axis 154.

In the cylindrical portion 152, a reflector 142 for increasing the efficiency for the bottom heater 132 to heat the wafer 310 is provided below the bottom heater 132 as viewed in the Z direction. The reflector 142 is configured of a material with a high heat resistance, such as carbon, SiC, carbon coated with SiC, or carbon coated with TaC. The reflector 142 may be configured of a single plate, or may be configured by laminating a plurality of plates. The reflector 142 contributes to suppressing power consumption of the heater during heating.

A heat-insulating material 144 is provided below the reflector 142 as viewed in the Z direction. The reflector 142 and the heat-insulating material 144 prevent the heat of the bottom heater 132 from being conveyed downward as viewed in the Z direction of the deposition apparatus 100.

The hot wall 116 provided laterally in the chamber 112 is configured of a material with a high heat resistance, such as carbon, SiC, carbon coated with SiC, or carbon coated with TaC. A side heater 138 is provided outside the hot wall 116 in the chamber 112. For the side heater 138, too, an electric-resistance-based heater can be used. The heat generated from the side heater 138 heats the deposition area 120, the wafer 310, the susceptor unit 210, and the like via the hot wall 116. A heat-insulating material 118 is provided between the side heater 138 and an inner wall of the chamber 112. The heat-insulating material 118 prevents the heat of the side heater 138 from being conveyed to the wall of the chamber 112.

An exhaust port 122 for exhausting a gas (exhaust gas) is provided at a lower portion of the chamber 112. The exhaust port 122 is connected to an exhaust system including a regulating valve and a vacuum pump (not illustrated). The inside of the chamber 112 is regulated to have a predetermined pressure via the exhaust system.

A reflector 124 that reflects radiant heat from the bottom heater 132 and the side heater 138 is provided above the deposition area 120 in the chamber 112 in order to increase the thermal efficiency. The reflector 124 can be configured of a plate using carbon, SiC, carbon coated with SiC, carbon coated with TaC, or the like. The reflector 124 may be configured of a single plate, or may be configured by laminating a plurality of plates. A plurality of gas holes (not illustrated) may be provided in the reflector 124 to supply a rectifying gas from a space above the reflector 124 to the deposition area 120. By supplying the rectification gas, convection of the gas in the vicinity of the reflector 124 of the deposition area 120 is suppressed, thus suppressing adhesion of a deposit to the reflector 124. A gas can be introduced into the space above the reflector from a gas pipe (not illustrated). A hydrogen gas, an argon gas, or the like is used as the rectification gas.

A gas supply unit 160 is provided above the chamber 112. The gas supply unit 160 supplies process gases such as a carrier gas, a source gas, and a doping gas to the deposition area 120. The gas supply unit 160 includes, for example, a first gas pipe 1611, a first partition wall 1612, a first gas plumbing 161, a second gas pipe 1621, a second partition wall 1622, a second gas plumbing 162, a third gas pipe 1631, a third partition wall 1632, and a third gas plumbing 163. A gas is supplied from the first gas plumbing 161 to the first gas pipe 1611, a gas is supplied from the second gas plumbing 162 to the second gas pipe 1621, and a gas is supplied from the third gas plumbing 163 to the third gas pipe 1631. The partition walls 1612, 1622, and 1632 prevent the gas supplied from the gas plumbing 161, 162, and 163 from being mixed inside the gas supply unit 160. When SiC is deposited, for example, the first gas pipe 1611 supplies a hydrogen gas, for example, to the deposition area 120. The second gas pipe 1621 supplies, for example, a silane gas as an SiC source gas, an HCl gas for improving the growth rate, and a hydrogen gas that functions as a carrier gas thereof, and the like to the deposition area 120. The third gas pipe 1631 supplies, for example, a propane gas as an SiC source gas, a nitrogen gas as a doping gas, and a hydrogen gas as a carrier gas thereof to the deposition area 120. FIG. 2 shows an example of a typical cross section of the deposition apparatus 100; in actuality, the gas supply unit 160 may include a plurality of first gas pipes 1611, a plurality of second gas pipes 1621, and a plurality of third gas pipes 1631. In addition, the arrangement of each of the first gas pipe 1611, the second gas pipe 1621, and the third gas pipe 1631 is not limited to a particular one, and any arrangement that improves the uniformity of the film thickness distribution, the carrier concentration distribution, or the like can be selected.

A pyrometer 171 is provided above the gas supply unit 160 for the purpose of measuring the temperature of the wafer 310. The pyrometer 171 measures the temperature of the wafer 310 through a pipe 173 and a window 172 configured of quartz glass and provided above the gas supply unit 160. The pyrometer 171 monitors temperatures at a plurality of positions from a central portion to an outer peripheral portion of the wafer 310.

When an SiC epitaxial film is deposited on the wafer 310, for example, the pressure in the chamber 112 is regulated at, for example, 26.7 kPa. The wafer 310 is heated to 1500 °C or higher using the bottom heater 132 and the side heater 138. The temperature of the upper surface of the wafer 310 is monitored using the pyrometer 171, and is maintained at 1620 °C with an accuracy within ±1 °C by feedback-controlling the output of the inside heater 133, for example. The wafer 310 is rotated, for example, at 600 rpm by the rotary holder 150. Under these conditions, when the SiC source gas and the doping gas are supplied from the gas supply unit 160 to the upper surface of the wafer 310, an SiC epitaxial film is deposited on the upper surface of the wafer 310. An SiC film with a thickness of, for example, 5 µm to 10 µm (hereinafter referring to a length in the Z direction) is deposited, which takes approximately 30 to 45 minutes.

### <Susceptor Unit>

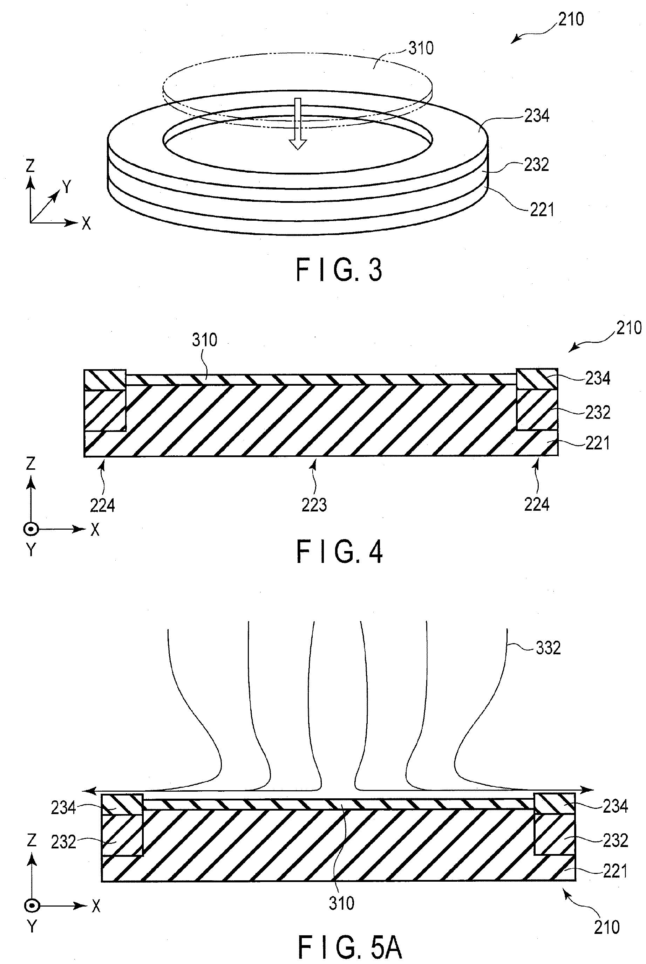

A configuration example of the susceptor unit 210 according to the present embodiment will be described. FIG. 3 is a perspective view schematically showing a configuration example of the susceptor unit 210. FIG. 4 is a cross-sectional view schematically showing a configuration example of the susceptor unit 210. As shown in these figures, the susceptor unit 210 includes at least a backside supporting member 221, a spacer 232, and a side guide 234.

The backside supporting member 221 is a supporting member that supports the wafer 310. The backside supporting member 221 has, for example, a substantially disc-like shape. The backside supporting member 221 includes a disk-shaped central portion 223 whose top and bottom surfaces are parallel and flat and which has substantially the same diameter as the wafer 310, and a peripheral portion 224 which is located in the periphery of the central portion 223 and has a thickness slightly smaller than that of the central portion 223.

The spacer 232 has, for example, an annular shape. The spacer 232 is configured to be placed on the peripheral portion 224 of the backside supporting member 221. That is, the inner diameter of the spacer 232 is, for example, substantially the same as the diameter of the central portion 223 of the backside supporting member 221. The outer diameter of the spacer 232 is, for example, substantially the same as the outer diameter of the backside supporting member 221. The spacer 232 is fitted into the backside supporting member 221 to surround the central portion 223 of the backside supporting member 221. The thickness of the spacer 232, for which various types with different thicknesses are prepared, as will be described later, is smaller than the difference in thickness between the central portion 223 and the peripheral portion 224 of the backside supporting member 221. The spacer is, as will be described later, an adjustment member for adjusting the position of the upper surface of the side guide 234 with respect to the upper surface of the wafer 310.

The side guide 234 has, for example, an annular shape. The side guide 234 is configured to be placed on the spacer 232. That is, the inner diameter of the side guide 234 is, for example, substantially the same as the diameter of the central portion 223 of the backside supporting member 221. The outer diameter of the side guide 234 is, for example, substantially the same as the outer diameter of the backside supporting member 221. The side guide 234 is fitted into the backside supporting member 221 to surround the central portion 223 of the backside supporting member 221. In other words, the side guide 234 is configured to be provided on the supporting member so as to surround the outer periphery of the wafer 310 when viewed from a direction (Z direction) perpendicular to the deposition surface of the wafer 310.

When the side guide 234 is overlaid on the spacer 232, the upper surface of the side guide 234 is configured to be located above the central portion 223 of the backside supporting member 221. That is, when the spacer 232 and the side guide 234 are fitted into the backside supporting member 221, a recess is formed on the central portion 223 of the backside supporting member 221. The wafer 310 is placed into the recess. Since the outer periphery of the wafer 310 is surrounded by the side guide 234, the wafer 310 is not displaced by a centrifugal force even when the susceptor unit 210 that holds the wafer 310 is rotated by the rotary holder 150 during deposition.

The thickness of the wafer 310 is not limited to the above-described one, but is on the order of, for example, 350 µm. The spacer 232 is set to have a maximum thickness on the order of, for example, 3 mm. From the viewpoint of strength, it is preferable that the thickness of the spacer 232 is 300 µm or larger. The side guide 234 has a thickness on the order of, for example, 1 mm. The wafer 310 has a diameter on the order of, for example, 100 to 150 mm. The width of the annular spacer 232 and the side guide 234 are on the order of, for example, 10 mm.

From the viewpoint of not disturbing the flow of the process gas flowing over the upper surface of the wafer 310, it is preferable that the position of the upper surface of the wafer 310 is substantially the same as the position of the upper surface of the side guide 234, or slightly above the upper surface of the side guide 234. On the other hand, when the wafer 310 is thin, the wafer 310 may be displaced beyond the side guide 234 under the influence of a centrifugal force caused by rotation during deposition. The position of the upper surface of the side guide 234 may be adjusted so as to be higher than the position of the upper surface of the wafer 310 by, for example, approximately 150 µm to prevent displacement of the wafer 310 (FIG. 4). That is, it is preferable that the position of the upper surface of the side guide 234 with respect to the deposition surface of the wafer 310 is within the above-described predetermined range.

The backside supporting member 221 can be configured of, for example, carbon, SiC, carbon coated with SiC, carbon coated with TaC, or the like. When an SiC epitaxial film is deposited on the wafer 310, carbon or carbon coated with TaC is preferably used as the backside supporting member 221. This is because, if SiC or carbon coated with SiC were used, SiC would sublimate at a high temperature, possibly causing the sublimated SiC to be transferred to the back surface of the wafer 310. The side guide 234 can be configured of, for example, carbon, SiC, carbon coated with SiC, carbon coated with TaC, or the like. At this time, the spacer 232 can be configured of, for example, carbon, SiC, carbon coated with SiC, carbon coated with TaC, or the like. When an SiC epitaxial film is deposited on the wafer 310, SiC can be used as the side guide 234. This is because carbon, carbon coated with SiC, and carbon coated with TaC tend to warp when cooled due to a difference in thermal expansion coefficient from the deposit (SiC) formed on the side guide 234. At this time, carbon or carbon coated with TaC can be used as the spacer 232. This is because, if SiC or carbon coated with SiC were used as the spacer 232, one of the SiC of the spacer 232 and the SiC of the side guide 234 would sublimate, causing the sublimated SiC to be easily transferred to the other SiC. Furthermore, in order to facilitate control of the temperature distribution of the wafer 310 during deposition, it is preferable that the side guide 234 and the spacer 232 are made of materials having an equivalent specific heat and an equivalent thermal conductivity. It is preferable that the difference between the specific heat of the side guide 234 and the specific heat of the spacer 232 is, for example, equal to or less than 0.3 J/gK. The specific heat of SiC, which varies depending on the manufacturing method, is approximately 0.65-0.67 J/gK, whereas the specific heat of carbon, which varies depending on the manufacturing method, is approximately 0.60-0.85 J/gK. Thus, a combination of SiC and carbon is suitable. The members configuring the susceptor unit 210 need to have a heat resistance that is high enough to withstand the temperature during the deposition process. In addition, it is preferable that the specific heat of the spacer 232 is equivalent to the specific heat of the material to be deposited. It is preferable that the difference between the specific heat of the spacer 232 and the specific heat of the material to be deposited is equal to or less than, for example, 0.3 J/gK. When SiC is used for the side guide 234, SiC formed by CVD can be used.

FIG. 5A is a diagram schematically showing a flow of a process gas 332 on the upper surface of the wafer 310 during deposition. The process gas 332 flows from the center to the outside along the upper surface of the wafer 310. When the height difference between the upper surface of the wafer 310 and the upper surface of the side guide 234 is small, the process gas 332 smoothly flows to the outside of the susceptor unit 210 without being disturbed even in the periphery of the side guide 234. In this case, the process gas 332 does not stagnate in the peripheral portion of the wafer 310, thus allowing the upper surface of the wafer 310 to obtain an excellent film thickness distribution and carrier concentration distribution.

In the deposition process, not only a film is deposited on the upper surface of the wafer 310, but also a deposit is formed on the upper surface of the side guide 234 in a similar manner. As such a deposition process is repeated, a deposit is sequentially formed on the upper surface of the side guide 234, and becomes thicker.

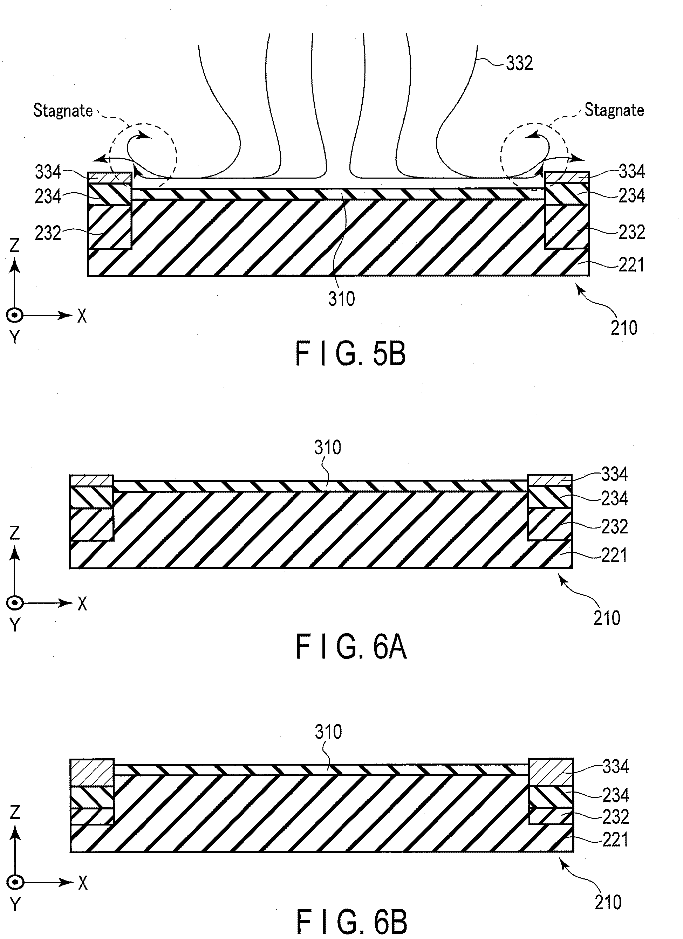

As shown in FIG. 5B, as the deposition process is repeated, the deposit formed on the upper surface of the side guide 234 becomes thicker. In this case, the height difference between the upper surface of the side guide 234 on which the deposit 334 has been formed and the upper surface of the wafer 310 prior to the deposition process, which is replaced every time the deposition process is performed, gradually increases. With the increase in the height difference, the flow of the process gas 332 is disturbed. This causes, for example, the process gas 332 to stagnate in the peripheral portion of the wafer 310. Such a change in the flow of the process gas 332 may change the film thickness distribution, the carrier concentration distribution, and the like of the film to be deposited on the wafer 310.

Therefore, in the susceptor unit 210 according to the present embodiment, as the deposit 334 becomes thicker, the spacer 232 is replaced with a thinner one, as shown in FIGS. 6A and 6B. In this manner, the height difference between the upper surface of the side guide 234 on which the deposit has been formed and the upper surface of the wafer 310 is adjusted to fall within a predetermined range.

The spacer 232 is replaced when, for example, the thickness of the deposit 334 has increased by 150 to 500 µm. If, for example, the spacer 232 is replaced when the thickness of the deposit 334 has increased by 150 um, assuming that a film of 10 µm is deposited in a single deposition process, for example, the spacer 232 is replaced every 15 deposition processes. In this example, assuming that the thickness of the thickest spacer 232 has a thickness of 3 mm (3000 µm), the spacer to be replaced next will be a spacer with a thickness of 2850 µm. A plurality of types of spacers 232 with different thicknesses are prepared, and are replaced according to the number of times of deposition processes, for example. Thus, in the present embodiment, a spacer set including a plurality of spacers 232 is prepared.

In the above-described example, an example has been described in which the backside supporting member 221 is configured of a single member; however, the configuration is not limited thereto. The backside supporting member 221 may be configured of a plurality of members. The backside supporting member 221 may be configured with its central portion raised, to facilitate placing of the wafer 310 on the susceptor unit 210 and taking out of the wafer 310 from the susceptor unit 210. In this case, the raised central portion and the other portion are configured as separate bodies, and function as the backside supporting member 221 as a whole. Furthermore, FIGS. 6A and 6B show aspects in which the upper surface of the backside supporting member 221 is in contact with the back surface of the wafer 310. However, the backside supporting member 221 may be configured, for example, to have a stepped structure on the upper surface of the backside supporting member 221 so as to provide a space between the upper surface of the backside supporting member 221 and the rear surface of the wafer 310.

### [Operation of System]

A sequential deposition process of a plurality of wafers 310 using the deposition system 1 according to the present embodiment will be described. The method described herein is a continuous deposition method including replacement of the spacer 232 and the side guide 234. All of the processes described herein may be performed fully automatically under the control of the control device 80. At this time, the control device 80 outputs a signal for control to each unit that performs an operation. Some of the processes described herein may be performed manually by an operator. At this time, the control device 80 may present information on a work to be performed by the operator to the display device 86. That is, the control device 80 outputs data and a signal for displaying the information to the display device 86.

At step S1, the total thickness of the films deposited on the upper surface of the side guide 234 is set to an initial value. When a new side guide 234 is used in the deposition process or when a side guide 234 from which a deposit has been removed by a cleaning process to be described later is used (step S9), the total thickness is set to 0 µm. As will be described at step S8 to be described later, a predetermined value is cumulatively added to the total film thickness every time the deposition process is performed, until the total film thickness is reset to the initial value (step S9 to step S1). When a deposit having a thickness substantially equal to a thickness of the film deposited on the wafer 310 so as to achieve a predetermined thickness is formed on the upper surface of the side guide 234 by a single deposition process on the wafer 310, this design value is used as the predetermined value to be added to the total film thickness. That is, since the thickness of a film to be deposited on the wafer 310 in a single deposition process on the wafer 310 is known as a design value, the thickness (film thickness) of the design value is added to the total film thickness every time the deposition process is repeated. When the thickness of the film deposited on the wafer 310 and the thickness of the film formed on the upper surface of the side guide 234 as a result of a single deposition process on the wafer 310 are significantly different from each other, the total film thickness can be set by taking a correlation between the thickness of the film deposited on the wafer 310 and the thickness of the deposit formed on the upper surface of the side guide 234.

At step S1, a spacer type indicator that indicates which of a plurality of spacers with different thicknesses is used is set as the type of the spacer to be used first. When a new side guide 234 is used and the thickest spacer 232 is used, an indicator that indicates the thickest spacer is set. When another spacer 232 is used, an indicator corresponding to that type of spacer is set.

The information on the indicator of the total film thickness and the spacer type is stored in, for example, the RAM 82 or the storage 84, and used for processing. These pieces of information stored in the RAM 82 or the storage 84 can be updated by the processes at steps S5, S8, and S9 to be described later.

At step S2, a height difference between an upper surface of the side guide 234 on which the deposit 334 has been formed (which is the upper surface of the side guide 234, since there is no deposit 334 in the initial state) and the upper surface of the wafer 310 that is the deposition surface is calculated based on the current value of the total thickness. Since the thickness of the spacer 232 and the thickness of the side guide 234 corresponding to the type of the spacer 232 being used are known, the position of the upper surface of the side guide 234 is based on the total film thickness. The position of the upper surface of the wafer 310 is also determined by the thickness of the wafer 310, which is known.

At step S3, it is determined whether or not the height difference calculated at step S2 is larger than a permissible value. Since a deposition process can be performed when the height difference is equal to or less than the permissible value, the processing advances to S6, where deposition preparations are performed, as will be described below, and a deposition process is performed. The permissible value is stored in the RAM 82 or the storage 84, for example, and can be suitably set.

When it is determined at step S3 that the height difference is larger than the permissible value, the processing advances to step S4.

At step S4, it is determined whether there is a replaceable spacer. A replaceable spacer is a spacer that is thinner than the spacer that is currently being used. When it is determined at step S4 that there is a replaceable spacer, the processing advances to step S5.

At step S5, the spacer 232 is replaced. That is, in the susceptor exchange chamber, the side guide 234 and the spacer 232 are removed from the backside supporting member 221, a thinner spacer is placed in place of the spacer that has been used until then, and the removed side guide 234 that is being used is placed thereon. At this time, the stored indicator that indicates the type of the spacer being used is changed to an indicator that indicates the type of the spacer with which the replacement has been made. Replacement of the spacer 232 may be manually performed by an operator, or a dedicated apparatus may be provided. Thereafter, the processing advances to step S6. That is, deposition preparations are performed and then a deposition process is performed, as will be described below.

Before the start of the deposition process, at step S6, deposition preparations such as transport of the wafer 310 and the susceptor unit 210 into the chamber 112 and adjustment of the temperature in the chamber 112 are performed.

At step S7, the deposition process is performed. That is, the susceptor unit 210 is rotated using the rotary holder 150 in the chamber 112 that has been heated to an appropriate temperature. In this state, a process gas is supplied, and a film such as an SiC crystal film is deposited on the wafer 310. At the same time, a deposit of, for example, SiC is formed on the upper surface of the side guide 234.

Since a new film has been deposited on the side guide 234 after the deposition process has ended at step S7, the thickness of the film deposited on the wafer 310 in the deposition process at step S7 or the thickness of the deposit formed on the upper surface of the side guide 234, which can be obtained by the relationship between the thickness of the deposit formed on the upper surface of the side guide 234 and the thickness of the film deposited on the wafer 310, measured in advance, for example, is added to the total film thickness. The stored total film thickness is updated to a value that indicates the film thickness of the deposit on the side guide 234 after the deposition process. That is, the total film thickness is updated based on the thickness of the film deposited on the wafer 310. Thereafter, the processing returns to step S2, where the height difference is calculated to determine whether the next deposition is permitted.

When it is determined at step S4 that there is no replaceable spacer, the processing advances to step S9. In this case, the thickness of the deposit 334 formed on the side guide 234 is too thick to be dealt with by replacement of the spacer 232. Therefore, at step S9, the side guide 234 and the spacer 232 are exchanged. That is, in the spacer exchange chamber, the side guide 234 and the spacer 232 that have been used until then are removed from the backside supporting member 221, and instead the thickest spacer 232 is placed thereon, and a new or cleaned side guide 234 on which a deposit 334 has not been formed is placed thereon. The spacer that has been used until then can be used repeatedly. Thereafter, the processing advances to step S1. That is, the stored total film thickness is reset to 0 pm, and the indicator corresponding to the type of the thickest spacer is set to the stored indicator that indicates the type of the spacer being used. The subsequent processing is the same as that described above. These procedures are repeated while a series of deposition processes are repeated, and are ended when the series of deposition processes are ended.

According to the above-described present embodiment, the height difference between the upper surface of the side guide 234 (the upper surface of the deposit 334) and the upper surface of the wafer 310 falls within a predetermined range as a result of the replacement of the spacer 232. Therefore, in the deposition process, the flow of the process gas on the upper surface of the wafer 310 does not make a change that would affect the thickness and properties of the film to be deposited, even after the deposition process is repeated.

Moreover, as described above, the specific heats of the spacer 232, the side guide 234, and the deposit 334 are approximately the same. Even if the thickness of the deposit 334 has increased, the total volume of the spacer 232, the side guide 234, and the deposit 334 falls within the permissible range. Thus, even if the deposit 334 becomes thicker, the combined heat capacity of the spacer 232, the side guide 234, and the deposit 334 remains constant within the permissible range. That is, the temperature of the outer peripheral portion of the wafer 310 can be made constant within the permissible range.

Furthermore, the position in the chamber 112 of the upper surface of the wafer 310 to be a target of a deposition process does not change through the repeated deposition processes. The wafer 310 remains to be placed on the susceptor unit 210. As described above, even if the deposit 334 becomes thicker or even if the spacer 232 is replaced, the deposition conditions can be made constant through the repeated deposition processes. As a result, the film to be deposited on the wafer 310 becomes homogeneous.

As described above, the position of the wafer 310 to be a target of the deposition process in the chamber 112 does not change through the repeated deposition processes. That is, even if the deposition process were repeated, the position of the upper surface of the wafer 310 on which the film is to be deposited does not change with respect to the other components of the chamber 112. This means that acquisition of information for grasping the state of the deposition process, such as temperature measurement by the pyrometer 171, can be stably performed. This also contributes to homogenizing the film to be deposited on the wafer 310.

The present embodiment is particularly effective in the case where an SiC film is to be deposited. The deposit may be removed by subjecting the side guide 234 on which the deposit 334 has been formed to a cleaning process. The cleaning process is a process of removing a deposit formed on the side guide 234 by a chemical process or a mechanical scraping process. When the deposit 334 formed on the upper surface of the side guide 234 is composed of Si or GaN, the deposit can be removed by a method such as gas etching in situ, subsequent to the deposition process (in-situ cleaning). However, in the case where the deposit 334 is composed of SiC, such a gas-based cleaning approach has not been established. Therefore, from the side guide 234 on which a deposit of SiC has been formed, the SiC deposit needs to be removed by, for example, polishing. The mechanical cleaning is time-consuming, and may damage the side guide 234. In the case of a chemical process, when, for example, the deposit is configured of SiC and the side guide 234 is also configured of SiC, a part of the side guide may be removed (over-etching may occur) in accordance with the removal of the deposit. That is, it is difficult to remove only the deposit of SiC formed on the upper surface of the side guide 234, and even if such removal were possible, it would take a high cost.

In the case of SiC, the thickness of the film deposited on the wafer 310 in a single deposition process, for example, is generally 5 µm or greater, which is relatively thick. The thickness of the deposit 334 on the side guide 234 that would not affect, for example, the thickness distribution of the film to be deposited on the wafer 310 is on the order of 150 to 500 µm at most. Thus, since the upper limit is reached by a small number of deposition processes, the height difference between the upper surface of the side guide 234 and the upper surface of the wafer 310 may become a problem, as described with reference to FIG. 5B. Therefore, if no measures were taken, the replacement frequency of the side guide 234 would increase, causing a cost problem.

According to the present embodiment, the above-described problem can be solved without providing a special mechanism such as a motor-based lifting mechanism in the susceptor unit 210 or the deposition apparatus 100. Furthermore, according to the present embodiment, the positional relationship between the susceptor unit 210 and the components of the deposition apparatus 100 such as the heater, the gas supply unit 160, and the pyrometer 171 is not changed. Therefore, it is possible to solve the above-described problem through a simple approach of replacing the spacer 232, while maintaining the setting conditions of the deposition apparatus 100 with respect to the wafer 310.

In the configuration of the deposition apparatus 100 according to the present embodiment, the bottom heater 132 is provided below the susceptor unit 210, and heating is performed from below the susceptor unit 210. In the present embodiment, the lower portion of the susceptor unit 210 does not change. The positional relationship between the backside supporting member 221 and the outside heater 134 or the positional relationship between the backside supporting member 221 and the wafer 310 does not change, for example. For this reason, various conditions remain unchanged through the repetition of the deposition processes, thus obtaining an advantageous effect of eliminating or facilitating adjustment of the deposition conditions.

In the present embodiment, a plurality of spacers with different thicknesses are prepared as the spacers 232, and the spacer to be used is selected according to the thickness of the deposit 334 that has been formed. However, the configuration is not limited thereto. Whether or not the spacer 232 is inserted may be selected depending on the thickness of the deposit 334. The number of spacers 232 that are simultaneously inserted into the susceptor unit 210 is not limited to one. A plurality of spacers 232 may be inserted, or the thickness may be adjusted according to the number of the spacers 232. However, for ease of handling and high durability, it is preferable that the spacer 232 have a certain level of thickness. Thus, when a plurality of spacers 232 are used, the thickness of the spacer 232 should be determined in consideration of the ease of handling. In any case, the spacer 232 is selectively inserted according to the thickness of the deposit.

### [Modifications]

Several modifications to the above embodiment will be described. Herein, differences from the above-described embodiment will be described, and the same portions will be denoted by the same reference numerals, and the description thereof will be omitted.

### <First Modification>

In the above-described embodiment, in order to adjust the positional relationship between the upper surface of the side guide 234 and the upper surface of the wafer 310, the thickness of the spacer placed under the side guide 234, that is, between the side guide 234 and the backside supporting member 221, is changed. In contrast, in the present embodiment, a spacer 242 is inserted between a backside supporting member 221 and a wafer 310. That is, by raising the position of the upper surface of the wafer 310 by means of the thickness of the spacer 242, the positional relationship between an upper surface of a side guide 234 and an upper surface of the wafer 310 is adjusted.

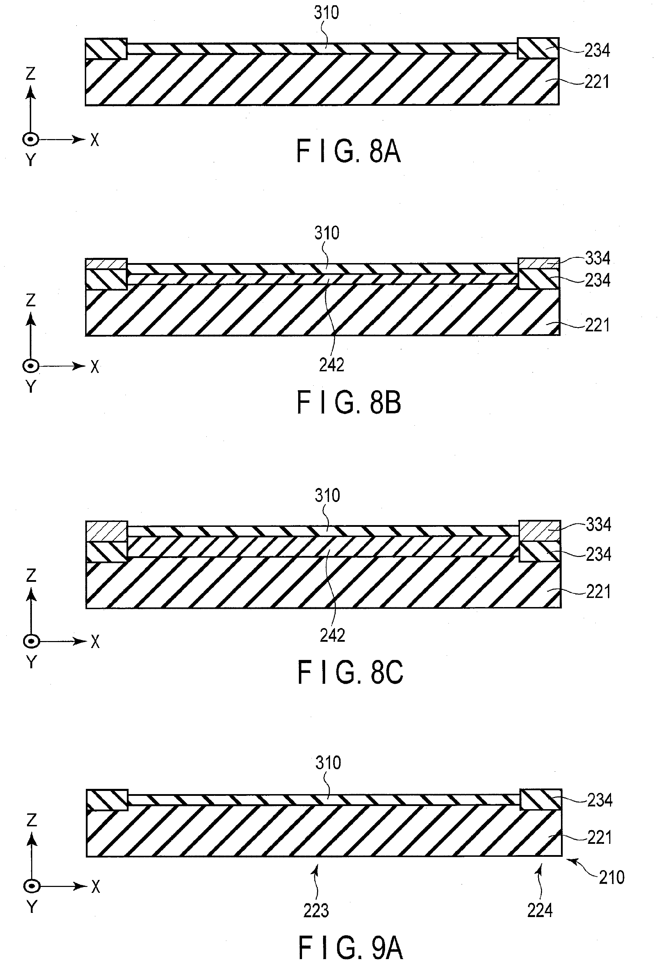

FIGS. 8A, 8B, and 8C are schematic diagrams of the present modification. As shown in FIG. 8A, when there is no deposit on the side guide 234, a wafer 310 is placed on a backside supporting member 221. As shown in FIG. 8B, when a deposit 334 is formed on the side guide 234, a spacer 242 with a thickness corresponding to the thickness of the deposit 334 is placed on the backside supporting member 221, and a wafer 310 is placed thereon. As shown in FIG. 8C, when the deposit 334 has become thicker, the spacer 242 is replaced with a thicker one accordingly. The spacer 242 may have a shape such as a ring shape which does not support the entire rear surface of the wafer 310.

In the present modification, the height difference between the upper surface of the deposit 334 on the side guide 234 and the upper surface of the wafer 310 falls within a predetermined range. Accordingly, similarly to the above-described embodiment, there will be no change such as an unacceptable disturbance in the flow of the process gas on the upper surface of the wafer 310 through the repeated deposition processes. Therefore, the film to be deposited on the wafer 310 becomes homogeneous.

### <Second Modification>

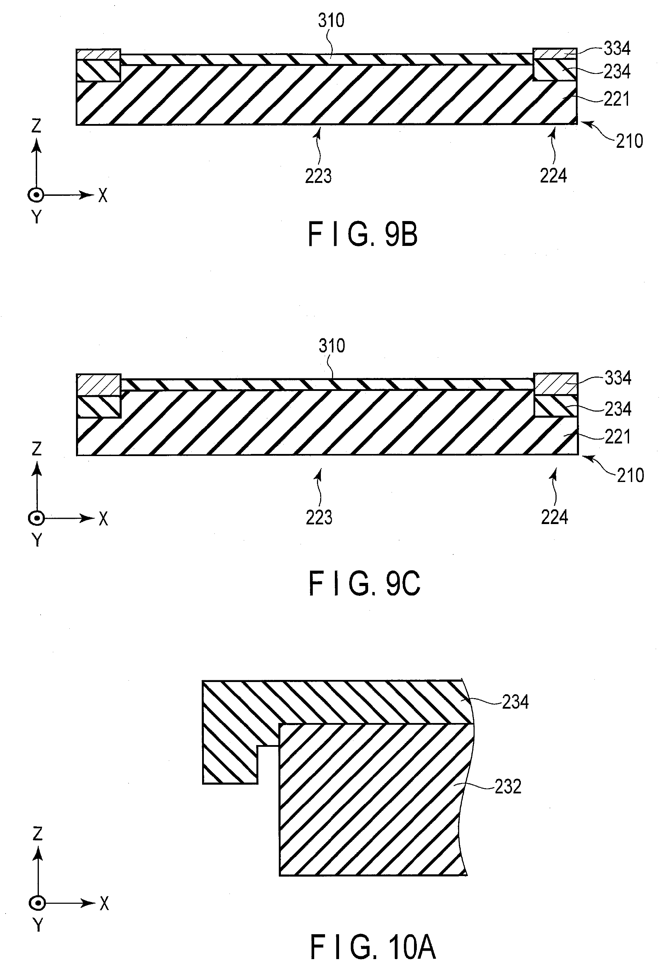

Instead of using the spacer 242 as in the above embodiment, the backside supporting member 221 may be replaced. That is, as shown in FIGS. 9A, 9B, and 9C, an appropriate backside supporting member 221 may be selected from among a plurality of backside supporting members 221 with different thicknesses of the central portion 223 and/or the peripheral portion 224, depending on the thickness of the deposit 334 on the side guide 234. The backside supporting member 221 need not have a structure that supports the entire backside of the wafer 310.

In the present modification, the height difference between the upper surface of the side guide 234 and the upper surface of the wafer 310 falls within a predetermined range. Accordingly, there will be no change such as an unacceptable disturbance in the flow of the process gas on the upper surface of the wafer 310 through the repeated deposition processes. Furthermore, by making adjustments in such a manner that the total size of the backside supporting member 221, the side guide 234, and the deposit 334 remains substantially the same, there will be no change in their heat capacities, the position of the upper surface of the wafer 310, the configuration of the backside of the wafer 310, and the like. This eliminates the necessity to change the setting conditions of the deposition apparatus 100 with respect to the wafer 310, and the film to be deposited on the wafer 310 becomes homogeneous.

By not using a spacer as in the present modification, the number of components can be reduced. On the other hand, by using a spacer, the backside supporting member 221 can be shared.

The above-described embodiment, the first modification, and the second modification may be used in combination. That is, the spacer 232 inserted between the backside supporting member 221 and the side guide 234 and the spacer 242 inserted between the backside supporting member 221 and the wafer 310 may be simultaneously used, or the backside supporting member 221 may be replaced.

### <Third Modification>

A reaction product generated by a process gas may adhere not only to the upper surface of the side guide 234 but also to the side surfaces of the side guide 234 and the spacer 232. Furthermore, due to processing variations between the spacer 232 and the side guide 234, a reaction product may enter between the spacer 232 and the side guide 234. If a reaction product enters between the side guide 234 and the spacer 232 and adheres to one of the side guide 234 and the spacer 232, the adhesion between the spacer 232 and the side guide 234 may gradually deteriorate, possibly causing part of the side guide 234 to float from the spacer 232. Such a state would cause rattling between the side guide 234 and the spacer 232, and adversely affect the stability when high-speed rotation is performed by the rotary holder 150. In addition, the contact areas provided by the side guide 234 and the spacer 232 would become different, and it will become difficult to keep the temperature of the outer peripheral portion of the wafer 310 constant within a permissible range.

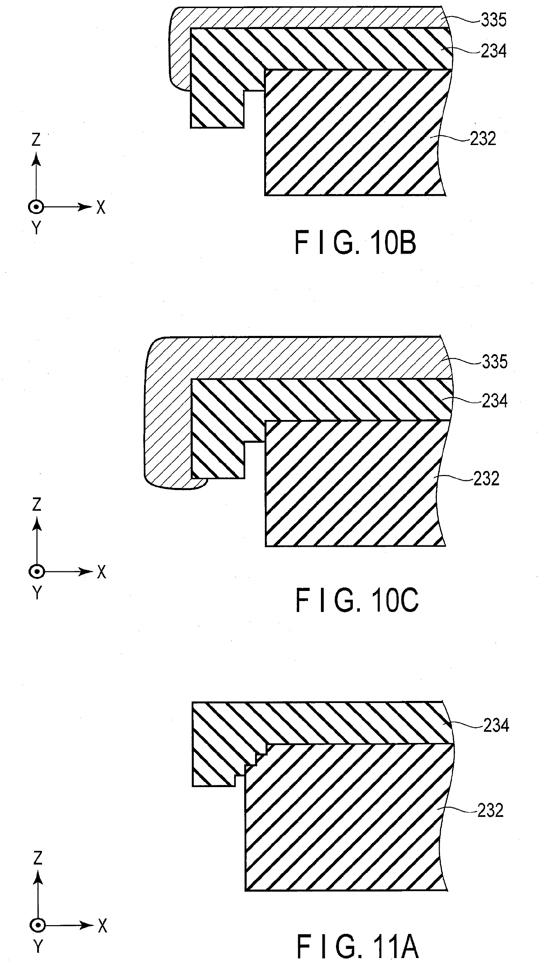

Thus, the shape of the peripheral portion of the side guide 234 may be a shape that covers the spacer 232, as in the present modification shown in FIG. 10A. By configuring the shape of the peripheral portion of the side guide 234 in this manner, as shown in FIGS. 10B and 10C, the reactive product 335 is less likely to enter the interface between the side guide 234 and the spacer 232.

### <Fourth Modification>

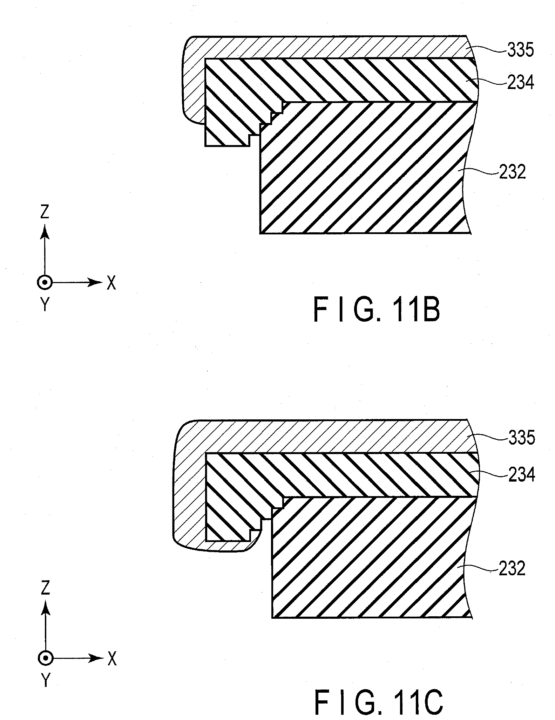

The spacer 232 and the side guide 234 may be configured in such a manner that the outer diameter of the spacer 232 can be changed, as in the present modification shown in FIG. 11A. The present modification is similar to the third modification in that the peripheral portion of the side guide 234 has a shape that covers the spacer 232. When the reactive product 335 does not wrap around the lower side of the outer periphery of the side guide 234, as shown in FIG. 11B, the outer radius of the spacer 232 is not changed. When the reactive product 335 adheres in an increasing amount and wraps around the lower part of the outer periphery of the side guide 234, as shown in FIG. 11C, the spacer 232 is replaced with one with a smaller outer radius. By thus reducing the outer diameter of the spacer 232, the spacer 232 and the side guide 234 may be configured in such a manner that the adhered reactive product 335 does not affect the interface between the side guide 234 and the spacer 232.

A gap may be provided between the side surface of the wafer 310 and the inner side surface of the side guide 234 in consideration of the processing variations, the thermal expansion, the transfer accuracy of the wafer 310, and the like. Moreover, a gap may be provided between the inner side surfaces of the spacer 232 and the side guide 234 and the side surface of the central portion 223 of the backside supporting member 221 in consideration of the processing variations and the thermal expansion.

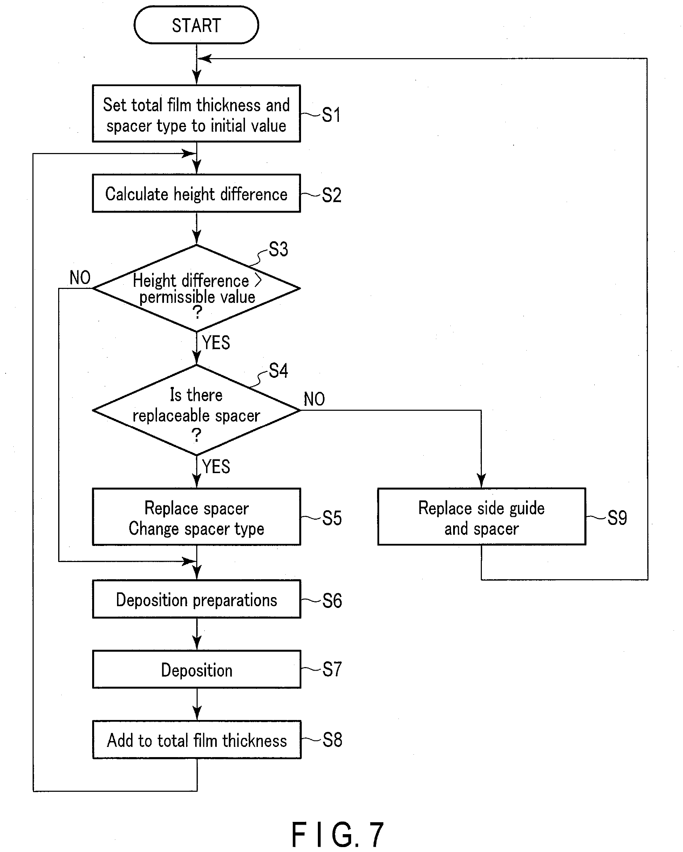

Furthermore, the deposit 334 is formed not only on the upper surface of the side guide 234 but also on the inner surface of the side guide 234, and may protrude in the inner peripheral direction of the side guide 234. In such a case, interference with the wafer 310 may occur, making it impossible to remove the wafer 310 from the susceptor unit 210. Therefore, the permissible value of the height difference described at step S3 of FIG. 7 may be determined taking into consideration not only the height difference but also the protrusion amount. The protrusion amount can be reflected in the permissible value at step S3 of FIG. 7 by obtaining the relationship with the thickness of the film to be deposited on the wafer 310 in advance. Since such a protruding portion of the deposit 334 can be removed in a short time by a simple grinding apparatus, a step of temporarily removing the side guide 234 and grinding the protruding portion of the deposit 334 may be added between step S3 and step S4.

While certain embodiments have been described, these embodiments have been presented by way of example only, and are not intended to limit the scope of the inventions. Indeed, the embodiments described herein may be embodied in a variety of other forms. Furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A deposition method comprising:
placing a wafer on a susceptor unit, the susceptor unit including: a supporting member configured to place a wafer thereon; a side guide that is provided on the supporting member and that surrounds at least a part of an outer periphery of the wafer; and a spacer configured to adjust a position between an upper surface of the wafer and an upper surface of the side guide;
depositing a predetermined film on the upper surface of the wafer placed and forming a film on the side guide;
adjusting the position of the upper surface of the side guide with respect to the upper surface of the wafer using the spacer, based on a thickness of the predetermined film deposited; and
placing a new wafer on the susceptor unit that has been adjusted in terms of the position for depositing a new predetermined film.

2. The deposition method according to claim 1, wherein
the supporting member includes a central portion and a peripheral portion that includes an upper surface located below an upper surface of the central portion, and
the spacer is provided between the side guide and the peripheral portion.

3. The deposition method according to claim 1, wherein the predetermined film is deposited by heating and rotating the wafer while supplying a process gas onto the upper surface of the wafer placed during deposition of the predetermined film.

4. The deposition method according to claim 1, wherein the position is adjusted by the spacer of a plurality of types with different thicknesses.

5. The deposition method according to claim 1, wherein after the predetermined film is deposited,
a thickness of the predetermined film is added to an initial value of a total film thickness.

6. The deposition method according to claim 5, wherein
when it is determined based on the thickness of total film added that a height difference between the upper surface of the wafer and the upper surface of the side guide is larger than a permissible value,
the position of the upper surface of the side guide with respect to the upper surface of the wafer is adjusted using the spacer.

7. The deposition method according to claim 1, wherein a peripheral portion of the side guide has a shape that covers an outer peripheral portion from above the spacer.

8. The deposition method according to claim 1, wherein an outer diameter of the spacer is equal to or smaller than an outer diameter of the supporting member.

9. The deposition method according to claim 1, wherein the side guide is removed after the predetermined film is deposited, and a film protruding from the side guide is ground.

10. The deposition method according to claim 1, wherein
the wafer is placed at a central portion of the supporting member.

11. The deposition method according to claim 1, wherein
a peripheral portion of the side guide has a shape that covers the spacer.

12. A deposition apparatus comprising:
a reaction chamber which performs a deposition process that deposits a predetermined film on an upper surface of a wafer;
a supply port through which a process gas is supplied to the reaction chamber;
an exhaust port through which an exhaust gas is discharged from the reaction chamber;
a heater that heats the wafer;
a susceptor unit which includes a supporting member that supports the wafer, a side guide that is provided on the supporting member so as to surround at least a part of an outer periphery of the wafer, and a spacer that can be replaced to adjust a position of an upper surface of the side guide with respect to the upper surface of the wafer based on a thickness of the predetermined film deposited.

13. A susceptor unit used for placing a wafer in a deposition apparatus that deposits a predetermined film on an upper surface of the wafer, comprising:
a supporting member that supports the wafer;
a side guide that is placed on the supporting member and that surrounds at least a part of an outer periphery of the wafer;
one or more spacers selected from among a plurality of spacers that are prepared in advance according to a thickness of the predetermined film deposited, in such a manner that a height difference between an upper surface of the side guide and the upper surface of the wafer falls within a predetermined range.

14. A spacer set used in, in a deposition apparatus that deposits a predetermined film on an upper surface of a wafer, a susceptor unit comprising a supporting member that supports the wafer, and a side guide that surrounds at least a part of an outer periphery of the wafer and that is placed on the supporting member, the spacer set comprising a plurality of spacers,
wherein
a position of the upper surface of the wafer with respect to an upper surface of the side guide is adjusted by selecting and inserting at least one of the plurality of spacers between the supporting member and the side guide, or between the supporting member and the wafer, according to a thickness of the predetermined film deposited.
